(19) Europäisches Patentamt
European Patent Office
Office européen des brevets

(11) **EP 4 651 382 A1**

(12) **EUROPEAN PATENT APPLICATION**

(43) Date of publication:
**19.11.2025   Bulletin 2025/47**

(21) Application number: **25169402.2**

(22) Date of filing: **09.04.2025**

(51) International Patent Classification (IPC):
***H03M 7/28*** *(2006.01)*          ***H03M 7/30*** *(2006.01)*

(52) Cooperative Patent Classification (CPC):
**H03M 7/28; H03M 7/3079; H03M 7/3084;**
**H03M 7/6064**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **14.05.2024   KR 20240063378**

(71) Applicant: **Samsung Electronics Co., Ltd.**
**Suwon-si, Gyeonggi-do 16677 (KR)**

(72) Inventor: **Nam, Jihoon**
**16678 Suwon-si, Gyeonggi-do (KR)**

(74) Representative: **Grünecker Patent- und**
**Rechtsanwälte**
**PartG mbB**
**Leopoldstraße 4**
**80802 München (DE)**

(54)    **ELECTRONIC DEVICE FOR COMPRESSING DATA AND OPERATION METHOD THEREOF**

(57)    An electronic device for compressing data includes a compression unit, a search engine, and a compression controller. The search engine includes a first buffer, a second buffer, and a plurality of comparators configured to perform matching between data stored in the first buffer and data stored in the second buffer. The compression controller is configured to determine a structure of the search engine, adjust a connection between the first buffer and the second buffer based on the determined structure and cause the compression unit to perform compression on target data using the search engine.

**FIG. 1**

**Description**

1. Technical Field

The following description is directed to an electronic device for compressing data and an operation method thereof.

2. Discussion of Related Art

When storing data in a memory, the data may be compressed to reduce a space occupied by the data. The data compression may be performed by hardware-based data compression or software-based data compression.
The hardware-based data compression may use dedicated hardware components to compress or decompress data. Examples of the dedicated hardware components include central processing units (CPUs), graphical processing units (GPUs) or network devices. Dedicated hardware components typically consume less energy than software-based compression but are less flexible since they rely on specific algorithms implemented in the hardware.
The software-based data compression may use software algorithms to compress or decompress data. Examples of the software algorithms include zlib, Huffman coding and Lempel-Ziv. While software-based data compression is flexible, it may be slow for large datasets and result in high CPU and memory usage.
Some of these compression algorithms perform a search to identify and exploit patterns or redundancies in the data to compress the data. However, the search may use too many resources of a system, and reduce performance of the system.

SUMMARY

The invention is claimed in the independent claims. Preferred embodiments are specified in the dependent claims.
According to an embodiment, an electronic device includes a compression unit, a search engine, and a compression controller. The search engine includes a first buffer, a second buffer, and a plurality of comparators configured to perform matching between data stored in the first buffer and data stored in the second buffer. The compression controller is configured to determine a structure of the search engine, adjust a connection between the first buffer and the second buffer based on the determined structure and cause the compression unit to perform compression on target data using the search engine.
The search engine may include a first circuit configured to determine a size of the first buffer for transmitting the target data, and a second circuit configured to determine a size of the second buffer for transmitting the target data.
The compression controller may be further configured to determine the structure by controlling the first circuit and the second circuit based on information related to compression determined based on the target data.
The search engine may include a third circuit connected to a fourth circuit through a portion of the plurality of comparators and configured to change the connection between the first buffer and the second buffer, and the fourth circuit connected to the third circuit through a portion of the plurality of comparators and configured to change the connection between the second buffer and the first buffer.
The compression controller may be further configured to determine the structure by controlling the third circuit and the fourth circuit based on information related to compression determined based on the target data.
The compression controller may be further configured to determine the structure of the search engine to be a first structure or a second structure, where in the first structure, a size of the second buffer may be greater than in the second structure, and in the second structure, a size of the first buffer may be greater than in the first structure.
In the first structure, the size of the second buffer may be at least twice as large as it is in the second structure, and in the second structure, the size of the first buffer may be at least twice as large as it is than in the first structure.
The compression controller may be further configured to change the structure of the search engine based on information related to compression determined based on the target data.
The compression controller may be further configured to determine the structure according to the information related to compression predetermined based on a structure of the target data.
The compression controller may be further configured to obtain a value indicating a distribution of the data obtained by an analysis of the target data, determine the information related to compression based on whether the value exceeds a threshold value, and determine the structure based on the information related to compression.
The compression controller may be further configured to, when an analysis time of the target data is longer than a movement time of the target data, adjust the connection by determining the information related to compression based on an analysis result of a portion of the target data, and when the analysis of the target data has completed, update the information related to compression based on a completed analysis result, and adjust the connection based on the updated information related to compression.

The compression controller may be further configured to cause the compression unit to store information indicating the structure of the search engine together with compressed target data.

According to an embodiment, an electronic device includes a host processor and a compression controller. The host processor is configured to provide a compression command for target data subject to compression. The compression controller is configured to determine a structure of a search engine, adjust a connection between a first buffer and a second buffer included in the search engine based on information related to compression determined based on the target data upon receipt of the compression command from the host processor, and cause a compression unit to perform compression on the target data subject to compression using the search engine.

According to an embodiment, an operation method of an electronic device includes: determining a structure of a search engine including a first buffer, a second buffer, and a plurality of comparators configured to match data stored in the first buffer with data stored in the second buffer; adjusting a connection between the first buffer and the second buffer based on the determined structure; and causing a compression unit to perform compression on target data subject to compression using the search engine.

The search engine may include a first circuit configured to determine a size of the first buffer for transmitting the target data, and a second circuit configured to determine a size of the second buffer for transmitting the target data.

The search engine may include a third circuit connected to a fourth circuit through a portion of the plurality of comparators and configured to change the connection between the first buffer and the second buffer, and the fourth circuit connected to the third circuit through a portion of the plurality of comparators and configured to change the connection between the second buffer and the first buffer.

The determining of the structure of the search engine may include determining the structure of the search engine to be a first structure or a second structure, wherein, in the first structure, a size of the second buffer may be greater than in the second structure, and in the second structure, a size of the first buffer may be greater than in the first structure.

The determining of the structure of the search engine may include changing the structure of the search engine based on information related to compression determined based on the target data.

The operation method may further include causing the compression unit to store information indicating the structure of the search engine together with compressed target data.

According to an embodiment, an electronic device includes a compression unit, a search engine, and a controller. The search engine includes a first buffer having two first sub-buffers, a second buffer having four second sub-buffers, and a plurality of comparators configured to perform matching between data stored in the first buffer and data stored in the second buffer. The controller is configured to determine a region comprising all of the second sub-buffers of a first size and one of the first sub-buffers during a first mode, determine the region comprising two of the second sub-buffers of a second size larger than the first size and all of the first sub-buffers during a second mode and cause the compression unit to perform compression on target data using the region.

BRIEF DESCRIPTION OF THE DRAWINGS

FIG. 1 is a diagram illustrating an electronic device according to an embodiment.
FIG. 2 is a diagram illustrating a search engine.
FIGS. 3 and 4 are diagrams illustrating a compression rate according to the size of a first buffer and a second buffer.
FIG. 5 is a diagram illustrating a search engine according to an embodiment of the present disclosure.
FIGS. 6 to 10 are diagrams illustrating a circuit to implement a search engine according to an embodiment of the present disclosure.
FIG. 11 is a diagram illustrating metadata addition according to an embodiment of the present disclosure.
FIG. 12 is a diagram illustrating control of a compression controller according to an embodiment of the present disclosure.
FIGS. 13 and 14 are diagrams illustrating data compression according to an analysis time of data and an input time of the data according to an embodiment of the present disclosure.
FIG. 15 is a flowchart illustrating an operation of an electronic device according to an embodiment.

DETAILED DESCRIPTION

The following detailed description is provided as an example, but various alterations and modifications may be made to the embodiments. Accordingly, the embodiments are not construed as limited to the disclosure and should be understood to include all changes, equivalents, and replacements within the idea and the technical scope of the disclosure.

It should be noted that if one component is described as being "connected", "coupled", or "joined" to another component, another component may be "connected", "coupled", and "joined" between the two components, although the first component may be directly connected, coupled, or joined to the second component.

The singular forms "a," "an," and "the" are intended to include the plural forms as well, unless the context clearly indicates otherwise.

Hereinafter, embodiments will be described in detail with reference to the accompanying drawings. When describing the embodiments with reference to the accompanying drawings, like reference numerals refer to like elements and a repeated description related thereto will be omitted.

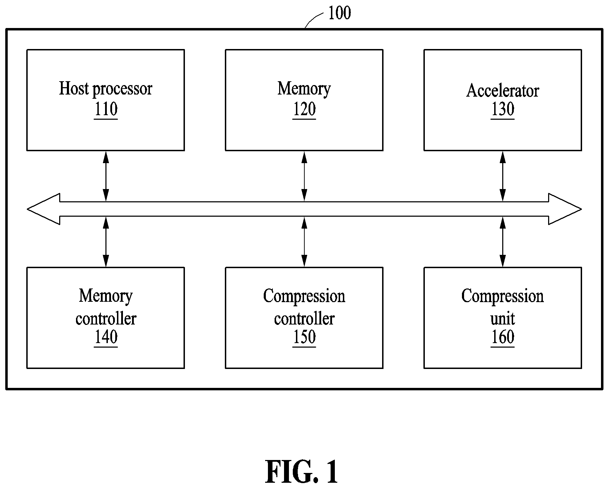

FIG. 1 is a diagram illustrating an electronic device according to an embodiment.

Referring to FIG. 1, an electronic device 100 may include a host processor 110, a memory 120, an accelerator 130, a memory controller 140 (e.g., a first controller circuit), a compression controller 150 (e.g., a second controller circuit), and a compression unit 160 (e.g., a compression circuit). The host processor 110, the memory 120, the accelerator 130, the memory controller 140, the compression controller 150, and the compression unit 160 may communicate with each other via a bus 170. However, this is an example and the present disclosure is not limited thereto. For example, the host processor 110, the memory 120, the accelerator 130, the memory controller 140, the compression controller 150, and the compression unit 160 may communicate with each other via a network on a chip (NoC), peripheral component interconnect express (PCIe), etc.

In the example of FIG. 1, only components related to embodiments described herein are illustrated in the electronic device 100. Thus, the electronic device 100 may also include other general-purpose components, in addition to the components illustrated in FIG. 1.

The host processor 110 may perform overall functions for controlling the electronic device 100. The host processor 110 may control the electronic device 100 overall by executing programs and/or instructions stored in the memory 120. In addition, the host processor 110 may generate a compression command with respect to data and may provide the compression command to the compression controller 150. The host processor 110 may be implemented as a central processing unit (CPU), a graphics processing unit (GPU), an application processor (AP), and the like, which are included in the electronic device 100, but examples of which are not limited thereto.

The memory 120 may be hardware for storing data having been processed or to be processed in the electronic device 100. In addition, the memory 120 may store an application, a driver, and the like to be driven by the electronic device 100. The memory 120 may include volatile memory (e.g., dynamic random access memory (DRAM)) and/or non-volatile memory.

The electronic device 100 may include the accelerator 130 for performing an operation. A separate dedicated processor, that is, the accelerator 130, may more efficiently process an operation, due to characteristics of the operation, than the general-purpose host processor 110. In this case, one or more processing elements (PEs) included in the accelerator 130 may be used. The PEs may be implemented by one or more logic circuits. The accelerator 130 may correspond to, for example, a neural processing unit (NPU), a tensor processing unit (TPU), a digital signal processor (DSP), a GPU, a neural engine, and the like that perform an operation according to a neural network.

The electronic device 100 may include the memory controller 140 causing the memory 120 to efficiently utilize its capacity. The memory controller 140 may be included in the host processor 110 or the memory 120 depending on the embodiment. However, this is an example and the present disclosure is not limited thereto.

The compression controller 150 may control the compression of data. When the compression controller 150 receives a compression command from the host processor 110, the compression controller 150 may control the compression unit 160 to compress data.

In an embodiment, the compression unit 160 includes a search engine (e.g., a logic circuit) to perform a search or pattern matching for compressing the data. The search engine may include a first buffer and a second buffer. The search engine may match data using the first buffer and the second buffer. The matching may be a process of determining whether repetitive data exists or whether a pattern exists in the data. The compression unit 160 may be included in the host processor 110, the accelerator 130 or the memory controller 140 depending on the embodiment. In addition, the compression unit 160 may be disposed between the compression controller 150 and the bus 170 depending on the embodiment. However, this is an example and the present disclosure is not limited thereto.

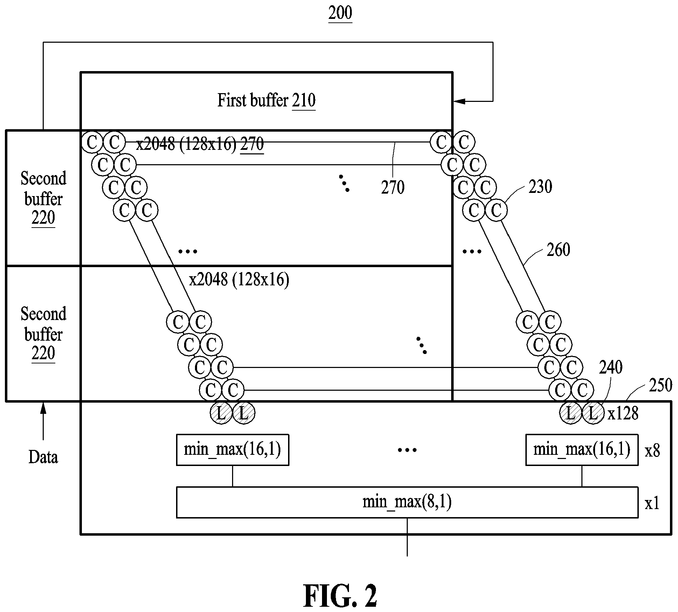

FIG. 2 is a diagram illustrating the search engine according to an embodiment.

Referring to FIG. 2, a search engine 200 having a size of 128 bytes x 32 bytes is illustrated. The search engine 200 may include one first buffer 210 having a size of 128 bytes and two second buffers 220 having a size of 16 bytes. Accordingly, the size of the search engine 200 may be 128 bytes x 32 bytes. However, the number and size of the first buffer 210 and the second buffer 220 are only examples, and the present disclosure is not limited thereto. The search engine 200 may be operated as a near search engine for performing a near search.

Depending on the embodiment, a horizontally disposed buffer may be referred to as the first buffer and a vertically disposed buffer may be referred to as the second buffer. Alternatively, depending on the embodiment, a horizontally disposed buffer may be referred to as the second buffer and a vertically disposed buffer may be referred to as the first buffer. However, for ease of description, the present disclosure assumes that a horizontally disposed buffer is the first buffer and a vertically disposed buffer is the second buffer. However, the description provided below may be identically applied to a case in which a horizontally disposed buffer is the second buffer and a vertically disposed buffer is the first buffer.

The first buffer 210 may include processed data. For example, the first buffer 210 may include data on which a matching has been performed. The first buffer 210 may be referred to as a search buffer, a history buffer, a search window, or a reference buffer.

The second buffer 220 may include data before processing. The second buffer 220 may include data on which a matching will be performed. The second buffer 220 may be referred to as a look-ahead buffer. The unprocessed data included in the second buffer 220 may be moved to the first buffer 210 after the data has been processed.

The first buffer 210 and the second buffer 220 may include cells (e.g., memory cells), respectively. A cell may correspond to 1 byte. For example, the 128-byte first buffer 210 may include 128 cells. For example, the 16-byte second buffer 220 may include 16 cells.

Each cell of the first buffer 210 may be connected to each cell of the second buffer 220. A comparator 230 (e.g., a comparator circuit) may be disposed in a portion in which each cell of the first buffer 210 is connected to (in other words, intersects with) each cell of the second buffer 220. In other words, the comparator 230 may be disposed in a portion in which rows 270 (e.g., lines connected to the cells of the second buffer 220) intersects with columns 260 (lines connected to the cells of the first buffer 210). Accordingly, the search engine 200 having the size of 128 bytes x 32 bytes may have 128 x 32 = 4096 comparators 230.

The comparator 230 may determine whether data stored in a cell of the first buffer corresponding to a location where the comparator 230 is disposed is the same as (in other words, matches) data stored in a cell of the second buffer. For example, when an intersecting cell of the first buffer 210 at a location where the comparator 230 is disposed includes the character "A" and a cell of the second buffer 220 indicates the character "A", the comparator 230 determines that the cell of the first buffer 210 and the cell of the second buffer 220 include the same data or match. In other words, the comparator 230 may determine that the intersecting cell of the first buffer 210 at the location where the comparator 230 is disposed matches the cell of the second buffer 220.

An encoder 240 (e.g., a length encoder) may be disposed at an end of each of the columns 260 of the search engine 200. The encoder 240 (e.g., an encoder circuit) may determine the number of matches between intersecting cells of the first buffer 210 at the row where the encoder 240 is disposed and cells of the second buffer 220 (in other words, a match length). For example, referring to FIG. 2, 32 comparators may be disposed in one column, and if it is determined that results of the seven comparators thereof are the same, the encoder 240 may determine that the number of matches is seven.

The search engine 200 may determine the longest match length based on a maximum (max) match length selector 250 (e.g., a logic circuit). The max match length selector 250 may include a plurality of selectors. For example, the max match length selector 250 may include eight selectors (or first selectors) connected to 16 columns and a second selector connected to the first selectors.

Data may be post-processed by various algorithms based on matching information obtained by the search engine 200 and may be compressed in a compression engine. The matching information may include the longest match length information. For example, the data may be post-processed by an algorithm, such as lempel-ziv-storer-szymanski (LZSS) based on the matching information obtained by the search engine 200 and may be compressed in the compression engine.

As a result, as the number of matches between the first buffer 210 and the second buffer 220 increases, the data may be compressed better. Hereinafter, a relationship between a compression rate (CR) and an increase in the size of the first buffer 210 and/or the second buffer 220 is described.

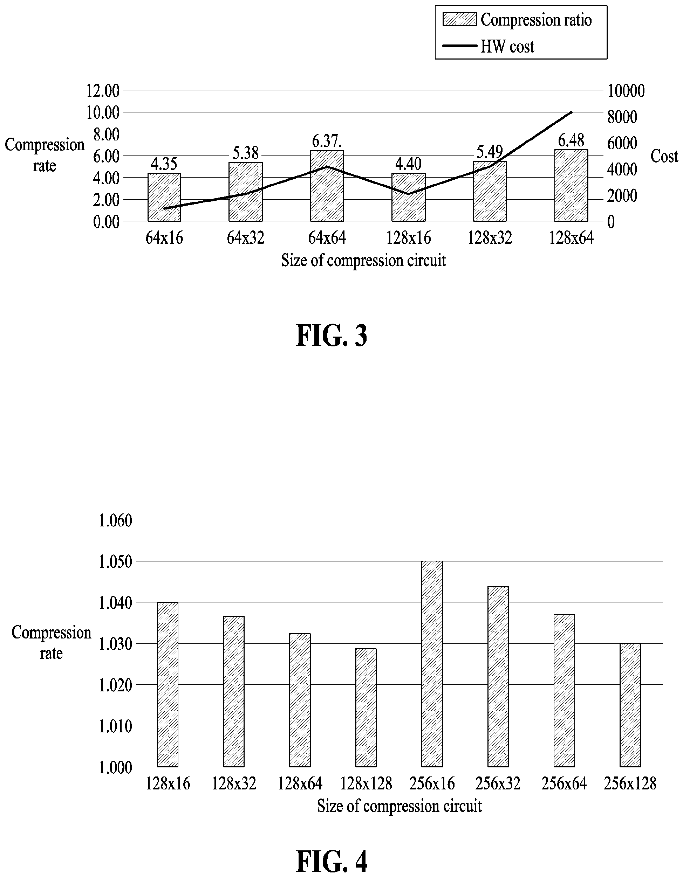

FIGS. 3 and 4 are diagrams illustrating a compression rate according to the size of a first buffer (e.g., 210) and a second buffer (e.g., 220).

Referring to FIG. 3, a graph showing a relationship among the size of a search engine, a compression rate, and a cost is illustrated. FIG. 3 is a graph according to a result of compressing data using search engines of various sizes. Referring to FIG. 3, in an A x B search engine, A may be the size of a first buffer and B may be the size of a second buffer.

Referring to a compression rate for search engines having sizes of 64 x 16, 64 x 32, and 64 x 64, as the size of the second buffer increases, the compression rate may increase. In addition, referring to the cost for search engines having sizes of 64 x 16, 64 x 32, and 64 x 64, as the size of the second buffer increases, the cost may also increase.

Similarly, referring to a compression rate for search engines having sizes of 128 x 16, 128 x 32, and 128 x 64, as the size of the second buffer increases, the compression rate may increase. In addition, referring to the cost for search engines having sizes of 128 x 16, 128 x 32, and 128 x 64, as the size of the second buffer increases, the cost may increase.

Referring to FIG. 4, a graph showing a relationship between the size of a search engine and a compression rate is illustrated. FIG. 3 may be a graph according to a result of compressing data that is not compressed well using search engines of various sizes.

Referring to a compression rate for search engines having sizes of 128 x 16, 128 x 32, and 128 x 64, as the size of the second buffer increases, the compression rate may decrease. On the other hand, referring to 128 x 16 and 256 x 16, as the size of the first buffer increases, the compression rate may increase.

In other words, referring to FIGS. 3 and 4, as the sizes of the first buffer and the second buffer increases, the data may be compressed well, but an increase in cost (in other words, resources used) may occur. In addition, referring to FIGS. 3 and 4, depending on whether data to be compressed (in other words, target data) is data that is well compressed, the size of the first buffer or the second buffer may need to be selectively increased to increase the compression rate.

Hereinafter, a method of adaptively increasing the size of the first buffer or the second buffer according to an embodiment of the disclosure is described.

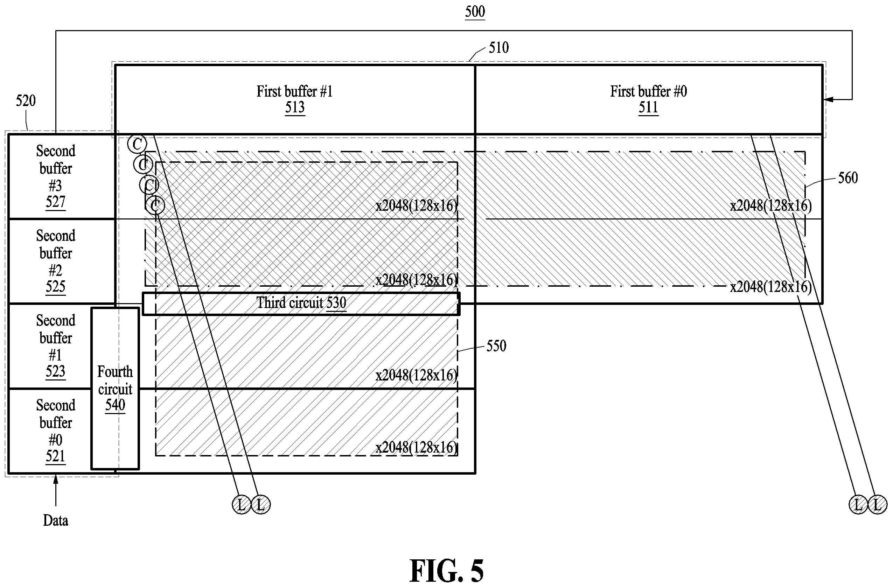

FIG. 5 is a diagram illustrating a search engine according to an embodiment of the present disclosure.

In FIG. 5, since FIG. 2 describes the comparator, the encoder, and the max match length selector, the descriptions thereof are omitted.

Referring to FIG. 5, a search engine 500 is illustrated according to an embodiment. The search engine 500 includes a first buffer and a second buffer. The first buffer may be divided into 2N buffers (e.g., first buffers). For example, when N = 1, the first buffer may be divided into a first buffer #0 511 and a first buffer #1 513. The second buffer may be divided into 2M buffers (e.g., second buffers). For example, when M=2, the second buffer may be divided into a second buffer #0 521, a second buffer #0 523, a second buffer #0 525 and a second buffer #3 527. N and M may be natural numbers.

According to an embodiment, the search engine 500 may include a plurality of first buffers and a plurality of second buffers. For example, the search engine 500 may include 2N first buffers (e.g., the first buffer #0 511 and the first buffer #1 513). The search engine 500 may include 2M second buffers (e.g., the second buffer #0 521 to the second buffer #3 527). N and M may be natural numbers.

In the present disclosure, for ease of description, according to data flow, the first buffer is indexed from right to left and the second buffer is indexed from bottom to top. Accordingly, upper and lower positions may vary depending on the indexing directions of the plurality of first buffers and the plurality of second buffers.

In FIG. 5, the sizes of the first buffer #0 511 and the first buffer #1 513 may be 128 bytes and the sizes of the second buffer #0 521 to the second buffer #3 527 may be 16 bytes, respectively.

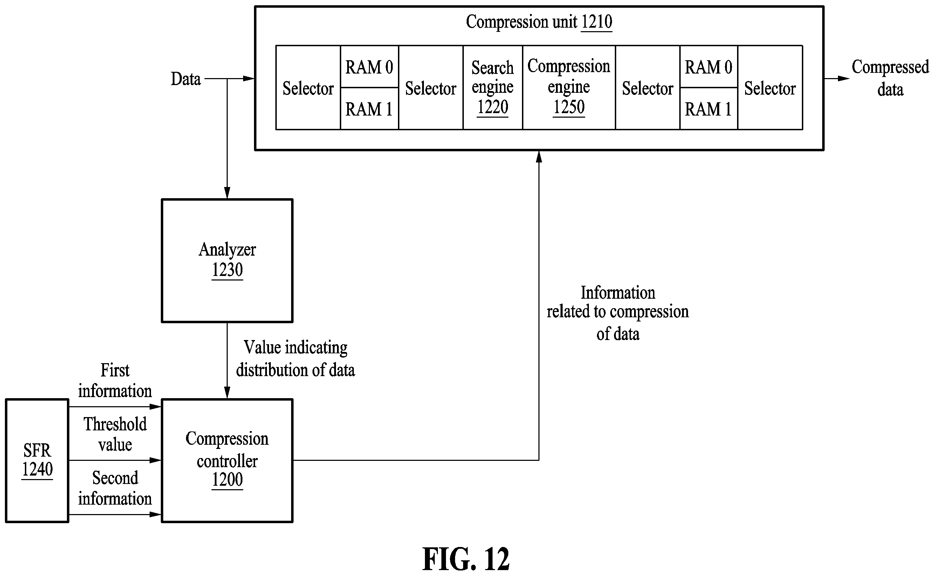

The compression controller (e.g., 150) may control or change the structure of the search engine 500 based on information related to compression. The information related to compression may be information related to a compression feature of the data subject to compression. For example, the information related to compression may be information about whether the data to be determined based on the structure of the data is compressed well. The information related to compression is described with reference to FIG. 12.

The compression controller may control the structure of the search engine 500 by controlling a connection relationship or a connection between the plurality of first buffers and the plurality of second buffers. The compression controller set or configure the search engine 500 to have one of a first structure 550 and a second structure 560. For example, the compression controller may change the structure of the search engine 500 by changing connections between the first buffers and the second buffers.

For ease of description, the present disclosure assumes that in the first structure 550, the total size of the second buffer is greater than in the second structure 560, and in the second structure 560, the total size of the first buffer is greater than in the first structure 550. However, this is an example and the present disclosure is not limited thereto. For example, in the first structure 550, the total size of the first buffer may be greater than in the second structure 560, and in the second structure 560, the total size of the second buffer may be greater than in the first structure 550.

The first structure 550 may include the first buffer #1 513 and the second buffer #0 521 to the second buffer #3 527. In other words, the size of the first structure 550 may be determined to be 128 x 64.

The second structure 560 may include the first buffer #0 511 to the first buffer #1 513 and a second buffer #2 525 to a second buffer #3 527. In other words, the size of the second structure 560 may be determined to be 256 x 32.

In other words, the size of the first structure 550 may be determined to be A x 2B and the size of the second structure 560 may be determined to be 2A x B. In this case, A and B may be natural numbers. For example, when the size of the first structure 550 is 128 x 64 and the size of the second structure 560 is 256 x 32, A is 128 and B is 32. In other words, in the first structure 550, the total size of the second buffer may be twice greater than in the second structure 560, and in the second structure 560, the total size of the first buffer may be twice greater than in the first structure 550. However, this is an example and the present disclosure is not limited thereto. For example, in the first structure 550, the total size of the second buffer may be greater twice or more than in the second structure 560, and in the second structure 560, the total size of the first buffer may be greater twice or more than in the first structure 550.

Ultimately, the first structure 550 and the second structure 560 may have the same size of 8192 (128 x 64 or 256 x 32), but the structures may be different from each other. In this case, since the sizes of the first structure 550 and the second structure 560 are the same, the number of comparators used in the first structure 550 and the second structure 560 may be the same, which is 8192. In other words, the number of comparators used in the first structure 550 may be the same as the number of comparators used in the second structure 560.

As the size of the second buffer increases, the number of comparison candidates to be compared with the data included in the first buffer may increase. As the size of the second buffer increases, the number of comparison candidates may increase, and thereby, the probability of better data compression may increase. The data having the characteristics that the data is well compressed may be data including many pieces of matching data with data included in the first buffer at a location adjacent to the data included in the first buffer. Accordingly, when the data has the characteristics of being compressed well, many comparison candidates to be compared with the data included in the first buffer may be required to increase the probability of compression. In other words, the first structure 550 may need to be used to increase the probability of performing compression. Referring to FIG. 3, when the data subject to compression has the characteristics of being compressed well, the size of the second buffer may need to increase.

The data of the second buffer may be input to the first buffer. In response to the data of the second buffer being input to the first buffer, old data among the data input to the first buffer may be sequentially removed from the first buffer. As the size of the first buffer increases, the data input to the first buffer may remain longer in the first buffer. In other words, as the size of the first buffer increases, more of the data in the first buffer may be compared with the data in the second buffer. Since more pieces of data are compared with the data of the second buffer as the size of the first buffer increases, the probability of compression may be high.

The data having the characteristics that the data is not compressed well may be data including few pieces of matching data with data included in the first buffer at a location adjacent to the data included in the first buffer. Accordingly, when the data has the characteristics that the data is not compressed well, the data included in the first buffer may not be removed and may exist in the first buffer for a long time. In other words, the second structure 560 may need to be used to increase the probability of performing compression. Referring to FIG. 4, when the data subject to compression has the characteristics that the data is not compressed well, the size of the first buffer may need to increase.

Accordingly, the compression controller may control or adjust the structure of the search engine 500 according to the first structure 550 or the second structure 560 based on the information related to compression.

A separate circuit (in other words, a logic) may be further required to control the structure of the search engine 500 using the first structure 550 or the second structure 560.

For example, the search engine 500 may include a first circuit 510 to select first buffers for transmitting data and a second circuit 520 to select second buffers for transmitting data. For example, the search engine 500 may include a third circuit 530 that selects a lower first buffer (e.g., the first buffer #1 513) or an upper first buffer (e.g., the first buffer #0 511) to determine data matching with the second buffers determined by the second circuit 520. For example, the search engine 500 may include a fourth circuit 540 that selects an upper second buffer (e.g., the second buffer #0 521 and the second buffer #1 523) or a lower second buffer (e.g., the second buffer #2 525 and the second buffer #3 527) to determine data matching with the first buffers determined by the first circuit 510.

The third circuit 530 may be disposed on a lower end of the first buffer #0 511. Alternatively, the third circuit 530 may be disposed on a lower end of the first buffer #1 513 and a boundary between the second buffer #2 525 and the second buffer #1 523.

The fourth circuit 540 may be disposed on a right side of the second buffer #0 521 and the second buffer #1 523. Alternatively, the fourth circuit 540 may be disposed on a right side of the second buffer #2 525 and the second buffer #3 527 and a boundary between the first buffer #0 511 and the first buffer #1 513. However, this is an example and the present disclosure is not limited thereto.

The structure of the search engine 500 may be controlled by the first structure 550 and the second structure 560 by the first circuit 510 and the fourth circuit 540. Hereinafter, the first circuit 510 to the fourth circuit 540 are described.

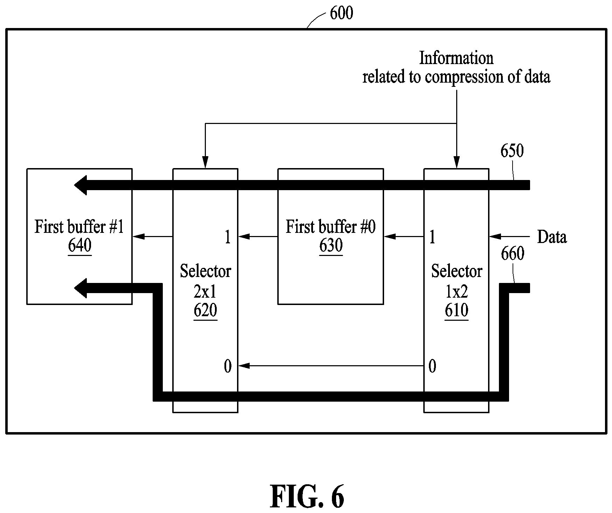

FIGS. 6 to 10 are diagrams illustrating a circuit to implement a search engine according to an embodiment of the present disclosure.

Referring to FIG. 6, a circuit 600 to select first buffers for transmitting data subject to compression (in other words, target data) is illustrated according to an embodiment. The first circuit 600 may include a 1 x 2 selector 610 and a 2 x 1 selector 620. The selector may receive information related to the compression of data and may transmit data based on the information. According to an embodiment, a multiplexer (MUX) or a demultiplexer (DMUX) may be used instead of the selector. For example, the 1 x 2 selector 610 may be implemented by the DMUX and the 2 x 1 selector 620 may be implemented by the MUX.

The compression controller may provide the information related to the compression of data to the first circuit 600. The information related to the compression of data is described with reference to FIG. 12. The information related to the compression of data may be 0 or 1. Here, 0 may be information to control the search engine by the first structure and 1 may be information to control the search engine by the second structure. Since the first structure and the second structure are described with reference to FIG. 5, the description thereof is omitted.

The first circuit 600 may receive data from the second buffer. When the first circuit 600 receives 0 as the information related to the compression of data, the first circuit 600 may transmit the data only to a first buffer #1 640 through a path 660. When the first circuit 600 receives 1 as the information related to the compression of data, the first circuit 600 may transmit the data to a first buffer #0 630 and the first buffer #1 640 through a path 650.

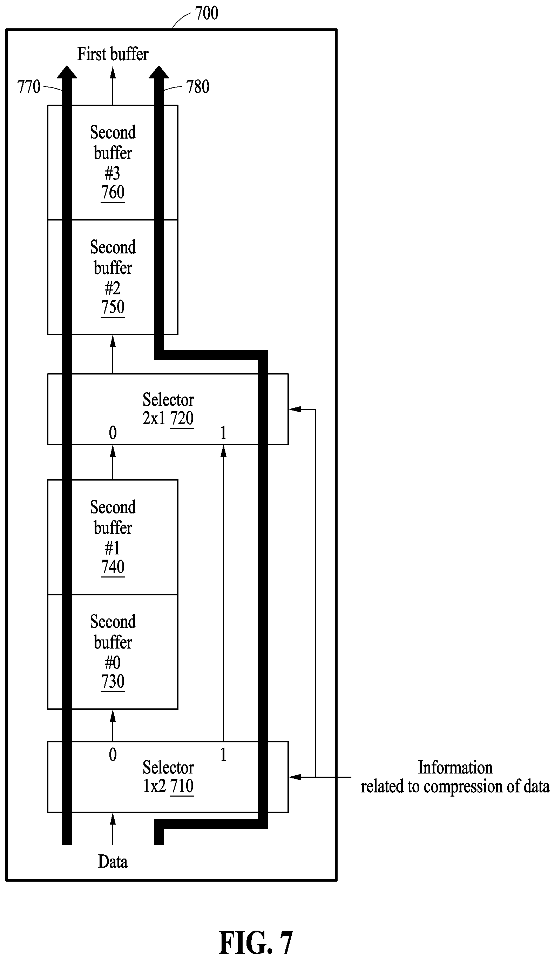

Referring to FIG. 7, a circuit 700 to select second buffers to transmit data subject to compression (in other words, target data) is illustrated according to an embodiment.

The second circuit 700 may include a 1 x 2 selector 710 and a 2 x 1 selector 720. According to an embodiment, a multiplexer (MUX) or a demultiplexer (DMUX) may be used instead of the selector.

The compression controller may provide the information related to the compression of data to the second circuit 700. The information related to the compression of data is described with reference to FIG. 12. The information related to the compression of data may be 0 or 1. Here, 0 may be information to control the search engine by the first structure and 1 may be information to control the search engine by the second structure. Since the first structure and the second structure are described with reference to FIG. 5, the description thereof is omitted.

The second circuit 700 may receive data. When the second circuit 700 receives 0 as the information related to the compression of data, the second circuit 700 may transmit the data to a second buffer #0 730, a second buffer #1 740, a second buffer #2 750, and a second buffer #3 760 through a path 770. When the second circuit 700 receives 1 as the information related to the compression of data, the second circuit 700 may transmit the data to the second buffer #2 750 and the second buffer #3 760 through a path 780.

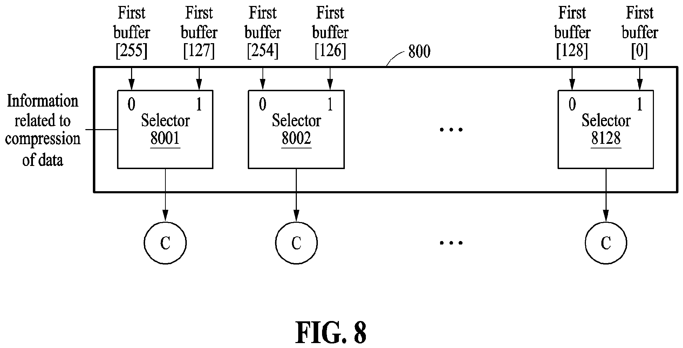

Referring to FIG. 8, a third circuit 800 to select a lower first buffer or an upper first buffer to determine data matching with second buffers determined by a second circuit is illustrated according to an embodiment.

The third circuit 800 may be connected to comparators. The third circuit 800 may be connected to a portion of a plurality of comparators and may be connected to a fourth circuit through a portion of the plurality of comparators.

The third circuit 800 may include a plurality of 2 x 1 selectors (e.g., 8001, 8002, ..., 8128). The number of 2 x 1 selectors may correspond to one half of the total size of the first buffers. For example, when the total size of the first buffers is 256 bytes obtained by 128 bytes x 2, the number of 2 x 1 selectors may be 128.

Each selector may receive information related to the compression of data from a compression controller. The information related to the compression of data is described with reference to FIG. 12. The information related to the compression of data may be 0 or 1. Here, 0 may be information to control the search engine by the first structure and 1 may be information to control the search engine by the second structure. Since the first structure and the second structure are described with reference to FIG. 5, the description thereof is omitted. The third circuit 800 may change a connection relationship between the first buffer and the second buffer based on the information related to the compression of data, and depending on a change in the connection relationship, the structure of the search engine may be changed to the first structure or the second structure.

The plurality of first buffers may be grouped as a group of the first buffer included both in the first structure and the second structure and a group of the first buffer included only in the second structure. For example, the first buffers can be divided into two groups: one group of first buffers that are included in both the first structure and the second structure, and another group of first buffers that are only included in the second structure. Each selector may be connected to one cell included in each group. The cells, which are included in each group and connected to the selector, may be a cell located at the same location in each group.

For example, the plurality of first buffers in FIG. 5 may be grouped as a group (in other words, the first buffer #1 513) of the first buffer included in both the first structure 550 and the second structure 560 and a group (in other words, the first buffer #0 511) included only in the second structure 560.

The selector may be connected to one cell included in each group and a cell connected to the same selector may be a cell located at the same location in each group. For example, based on an assumption that the indexing of cells included in the plurality of first buffers in FIG. 5 is from 0 to 255 from right to left, a selector 8001 may be connected to a first buffer [255] and a first buffer [127], and the first buffer [255] and the first buffer [127] may correspond to a last cell in each group. Similarly, a selector 8002 may be connected to a first buffer [254] and a first buffer [126], and the first buffer [254] and the first buffer [126] may correspond to a cell immediately previous to the last cell in each group. Similarly, a selector 8128 may be connected to a first buffer [128] and a first buffer [0], and the first buffer [128] and the first buffer [0] may correspond to a first cell in each group.

In the third circuit 800, when the selectors receive 0 as information related to the compression of data, the selectors may select a lower first buffer included in both the first structure and the second structure and may transmit data of the lower first buffer to a connected comparator. For example, in FIG. 5, when the selectors in the third circuit 530 receive 0, the selectors may transmit data of a group (in other words, the first buffer #1 513) of the first buffer included both in the first structure 550 and the second structure 560 to a connected comparator.

In the third circuit 800, when the selectors receive 1 as the information related to the compression of data, the selectors may select an upper first buffer included only in the second structure and may transmit data of the upper first buffer to the connected comparator. For example, in FIG. 5, when the selectors receive 1 in the third circuit 530, the selectors may transmit data on a group (in other words, the first buffer #0 511) of the first buffer included only in the second structure 560 to the connected comparator.

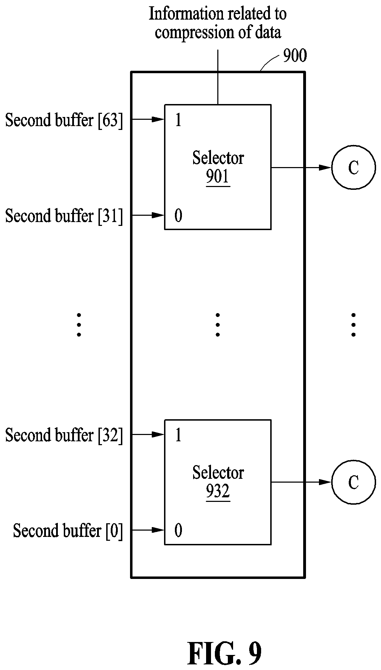

Referring to FIG. 9, a fourth circuit 900 that selects an upper second buffer and a lower second buffer is illustrated.

The fourth circuit 900 may be connected to comparators. The fourth circuit 900 may be connected to a portion of a plurality of comparators and may be connected to the third circuit through a portion of the plurality of comparators.

The fourth circuit 900 may include a plurality of 2 x 1 selectors (e.g., 901, ..., 932). The number of 2 x 1 selectors may correspond to a half of the total size of second buffers. For example, when the total size of the second buffers is 64 bytes obtained by 16 bytes x 4, the number of 2 x 1 selectors may be 32.

Each selector may receive information related to the compression of data from a compression controller. The information related to the compression of data is described with reference to FIG. 12. The information related to the compression of data may be 0 or 1. Here, 0 may be information to control the search engine by the first structure and 1 may be information to control the search engine by the second structure. Since the first structure and the second structure are described with reference to FIG. 5, the description thereof is omitted. The fourth circuit 900 may change a connection relationship between the first buffer and the second buffer based on the information related to the compression of data, and depending on a change in the connection relationship, the structure of the search engine may be changed to the first structure or the second structure.

The plurality of second buffers may be grouped as a group of the second buffer included both in the first structure and the second structure and a group of the second buffer included only in the first structure. For example, the second buffers can be divided into two groups: one group of second buffers that are included in both the first structure and the second structure, and another group of second buffers that are only included in the first structure. Each selector may be connected to one cell included in each group. The cells, which are included in each group and connected to the selector, may be a cell located at the same location in each group.

For example, in FIG. 5, the plurality of second buffers may be grouped as a group (e.g., the second buffer #2 525 and the second buffer #3 527) of the second buffer included in both the first structure 550 and the second structure 560 and a group (in other words, the second buffer #0 521 and the second buffer #1 523) included only in the first structure 550.

The selector may be connected to one cell included in each group and a cell connected to the same selector may be a cell located at the same location in each group. For example, based on an assumption that the indexing of cells included in the plurality of second buffers in FIG. 5 is from 0 to 63 from bottom to top, a selector 901 may be connected to a second buffer [63] and a second buffer [31], and the second buffer [63] and the second buffer [31] may correspond to a last cell in each group. Similarly, a selector 932 may be connected to a second buffer [32] and a second buffer [0], and the second buffer [32] and the second buffer [0] may correspond to a first cell in each group.

In the fourth circuit 900, when the selectors receive 0 as the information related to the compression of data, the selectors may select an upper second buffer included only in the first structure and may transmit data of the upper second buffer to the connected comparator. For example, in FIG. 5, when the selectors receive 0 in the fourth circuit 540, the selectors may transmit data of the upper second buffer (in other words, the second buffer #0 521 and the second buffer #1 523) included only in the first structure 550 to the connected comparator.

In the fourth circuit 900, when the selectors receive 1 as information related to the compression of data, the selectors may select a lower second buffer included in both the first structure and the second structure and may transmit data of the lower second buffer to the connected comparator.

For example, in FIG. 5, when the selectors receive 1 in the fourth circuit 540, the selectors may transmit data of the lower second buffer (in other words, the second buffer #2 525 and the second buffer #3 527) included in both the first structure 550 and the second structure 560 to the connected comparator.

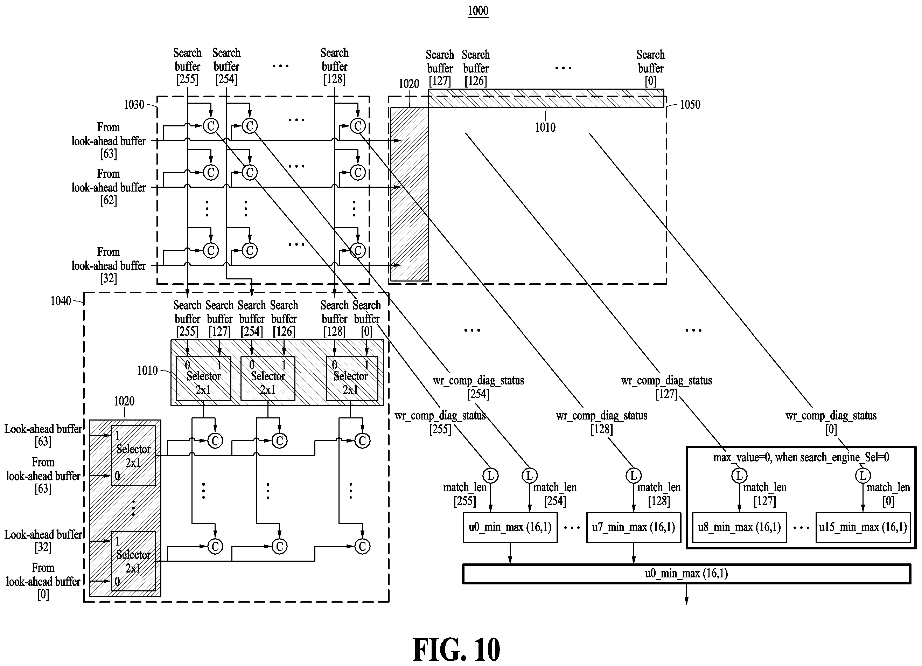

Referring to FIG. 10, a diagram schematically illustrating a search engine 1000 in which a third circuit 1010 and a fourth circuit 1020 described above are implemented is illustrated as an embodiment.

Since the third circuit 1010 and the fourth circuit 1020 are described with reference to FIGS. 8 and 9, the description thereof is omitted. For example, the third circuit 1010 may be implemented by the third circuit 800 and the fourth circuit 1020 may be implemented by the fourth circuit 900. The third circuit 1010 and the fourth circuit 1020 may be implemented in an area 1040 or an area 1050. In other words, the third circuit 1010 and the fourth circuit 1020 may be disposed in the area 1040 or the area 1050.

For ease of description, the structures of the third circuit 1010 and the fourth circuit 1020 in the area 1050 are omitted. The structures of the third circuit 1010 and the fourth circuit 1020 in the area 1050 may be the same as the structures of the third circuit 1010 and the fourth circuit 1020 in the area 1040.

Regardless of whether the third circuit 1010 and the fourth circuit 1020 are implemented in the area 1040 or the area 1050, an effect of controlling the search engine 1000 by the first structure or the second structure may be the same.

In other words, the comparison of a first buffer and a second buffer repeated in the first structure and the second structure may be performed in an area 1030, and the comparison of a first buffer and a second buffer varying depending on the first structure or the second structure may be performed in the area 1040 or the area 1050.

Ultimately, the structure of the search engine 1000 may be controlled by the first structure or the second structure as the search engine 1000 further includes separate circuits (e.g., the first circuit, the second circuit, the third circuit 1010, and the fourth circuit 1020).

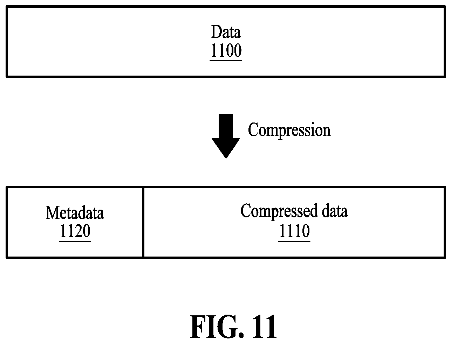

FIG. 11 is a diagram illustrating adding metadata according to an embodiment of the present disclosure.

Referring to FIG. 11, data 1100 and compressed data 1110 obtained by compressing the data 1100 by a search engine are illustrated. The compression controller may store structure information of a search engine used for compressing the data 1100 together with the compressed data 1110. The compressed data 1110 may include length information and distance information.

For example, when the structure of the search engine is the first structure, which is 128 x 64, the compressed data 1110 may include 7 bits of distance information and 6 bits of length information. When the structure of the search engine is the second structure, which is 256 x 32, the compressed data 1110 may include 8 bits of distance information and 5 bits of length information.

The structure information of the search engine used for compressing the data 1100 may be stored in metadata 1120. The structure information of the search engine may be used for decompressing the compressed data 1110 later. The structure information may indicate whether the first structure or the second structure was used to compress the data 1100.

The structure information of the search engine may be stored as one of bits of the metadata 1120. In this case, a bit of the metadata 1120 corresponding to the structure information of the search engine may represent information related to the compression of data used for controlling the search engine when compressing the data 1100. For example, when the bit of the metadata 1120 corresponding to the structure information of the search engine is 0, it may be recognized that the compressed data 1110 resulted from compressing the data 1100 by the search engine of the first structure. For example, when the bit of the metadata 1120 corresponding to the structure information of the search engine is 1, it may be recognized that the compressed data 1110 resulted from compressing by the data 1100 by the search engine of the second structure.

However, when the distance information and the length information are sufficiently great (e.g., distance information: 10 bits and length information: 8 bits), the structure information of the search engine need not be stored together.

Hereinafter, the information related to the compression of data is described.

FIG. 12 is a diagram illustrating the control of a compression controller according to an embodiment of the present disclosure.

Referring to FIG. 12, a compression controller 1200, a compression unit 1210, an analyzer 1230, and a special function register (SFR) 1240 are illustrated.

The compression unit 1210 may include a plurality of selectors, a plurality of RAMs, a search engine 1220, and a compression engine 1250 (e.g., a logic circuit). For example, target data subject to compression may be stored in RAM 0 or RAM 1 through a selector. The target data stored in RAM 0 or RAM 1 may be transmitted to the search engine 1220 through the selector. The search engine 1220 controlled by the first structure or the second structure may perform matching on the target data. The compression engine 1250 may compress the target data using a compression algorithm. The compression engine 1250 may perform compression on the target data based on the compression algorithm and matching information obtained by the search engine 1220. The data compressed in the compression engine 1250 may be stored in RAM 0 or RAM 1 through the selector. The compressed data stored in RAM 0 or RAM 1 may be selected by the selector and may be transmitted to other components of an electronic device.

The compression controller 1200 may control a connection relationship between a plurality of first buffers and a plurality of second buffers included in the search engine 1220 using the information related to the compression of data. In other words, the compression controller 1200 may control the structure of the search engine 1220 using the information related to the compression of data. The compression controller 1200 may control the search engine 1220 based on an input obtained from the SFR 1240.

The compression controller 1200 may obtain first information from the SFR 1240. The first information may include information related to compression or control information causing the compression controller 1200 to determine the information related to compression. The information related to compression included in the first information may be determined based on a structure of data (in other words, a distribution of data) subject to compression. In other words, when it is possible to know the structure of data subject to compression in advance, the information related to compression included in the first information may be predetermined.

For example, since a structure of data is expected to be compressed poorly since the data is randomly generated and there is little overlapping data, the information related to compression included in the first information may be predetermined to be 1. For example, when the data is based on a specific database (e.g., data in which blood types of a specific age are collected), the structure of data is expected to be compressed well, and therefore, the information related to compression included in the first information may be predetermined to be 0.

When the compression controller 1200 receives the first information from the SFR 1240 and the first information includes the information related to compression, the compression controller 1200 may control the search engine 1220 based on the information related to compression.

According to an embodiment, the compression controller 1200 obtains predetermined information related to compression based on the structure of data subject to compression with the first information and controls the structure of the search engine 1220 based on the information related to compression. In other words, the compression controller 1200 may control the search engine 1220 based on the information related to compression of the obtained first information without the need to determine a compression rate of the data subject to compression and compare it with a threshold value.

According to an embodiment, when the structure of the data subject to compression is not known in advance, the compression controller 1200 may obtain control information causing the compression controller 1200 to determine information related to compression with the first information. The compression controller 1200 may obtain a threshold value from the SFR 1240. The compression controller 1200 may obtain a value indicating a distribution of data from the analyzer 1230 (e.g., a logic circuit). The compression controller 1200 may compare a value indicating a distribution of data and the threshold value. The compression controller 1200 may determine the information related to the compression of data based on whether the value indicating the distribution of data exceeds the threshold value. For example, the compression controller 1200 may determine whether the information related to the compression of data indicates the first structure or the second structure by comparing the value indicating the distribution of data and the threshold value.

According to an embodiment, the value indicating the distribution of data is an entropy value. The analyzer 1230 may determine the entropy value based on Equation 1 shown below. In Equation 1, $H[Y]$ may denote an entropy value of data and K may denote the number that the entire data is able to represent. For example, 1 byte may allow 256 representations. In Equation 1, $p(y_k)$ may denote a probability in which a specific value appears among the number of possible representations by the entire data.

$$H[Y] = -\sum_{k=1}^{K} p(y_k) \log_2 p(y_k)$$

[Equation 1]

A great entropy value or an entropy value exceeding the threshold value may indicate that data is evenly distributed. In other words, data matching may not be performed well. If matching is not performed well, compression may not be performed well. Conversely, a small entropy value or an entropy value less than or equal to the certain threshold value may indicate that data is not evenly distributed. In other words, data matching may be performed well. If matching is performed well, compression may be performed well.

For example, it may be assumed that an entropy value calculated by Equation 1 represents a 1 byte distribution. In this case, as the entropy value approaches 8, data may not be compressed well, and as the entropy value approaches 1, the data may be compressed well. In this case, when the entropy value exceeds the threshold value, the data may have the characteristics that the data is not compressed well. Therefore, the second structure may need to be used to compress the data. In other words, the information related to the compression of data may be determined to be 1. Conversely, when the entropy value is less than or equal to the threshold value, the data may have the characteristics that the data is compressed well. Therefore, the first structure may need to be used to compress the data. In other words, the information related to the compression of data may be determined to be 0.

According to an embodiment, the value indicating the distribution of data may be a gini impurity value. The analyzer 1230 may determine the gini impurity value based on Equation 2 shown below. In Equation 2, $G[Y]$ may denote a gini impurity value and K may denote the number that the entire data is able to represent. For example, 1 byte may allow 256 representations. In Equation 2, $p(y_k)$ may denote a probability in which a specific value appears among the number of possible representations by the entire data.

$$G[Y] = \sum_{k=1}^{K} P(y_k)(1 - P(y_k))$$

[Equation 2]

A great gini impurity value or a gini impurity value exceeding the threshold value may indicate that data is evenly distributed. In other words, data compression may not be performed well. Conversely, a small gini impurity value or a gini impurity value less than or equal to the threshold value may indicate that data is not evenly distributed. In other words, data compression may be performed well. In this case, when the gini impurity value exceeds the threshold value, the data may have the characteristics that the data is not compressed well. Therefore, the second structure may need to be used to compress the data. In other words, the information related to the compression of data may be determined to be 1. Conversely, when the gini impurity value is less than or equal to the threshold value, the data may have the characteristics that the data is compressed well. Therefore, the first structure may need to be used to compress the data. In other words, the information related to the compression of data may be determined to be 0.

However, the determination of the structure of the search engine 1220 based on the entropy value and the gini impurity value described above is an example and the present disclosure is not limited thereto. For example, various methods of indicating a data distribution may be used to determine the structure of the search engine 1220.

According to an embodiment, the compression controller 1200 may obtain second information from the SFR 1240. The second information may be information indicating that an analysis time of data performed by the analyzer 1230 is greater than a data movement time. The data movement time may be the time in which the data moves to the compression unit 1210. For example, the data movement time may refer to the duration it takes for the data to be transferred to the compression unit. Alternatively, the data movement time may be the time in which the data moves to a component of the compression unit 1210. When the compression controller 1200 obtains the second information, the compression controller 1200 may determine information related to the compression of data based on an analysis result of a portion of data and may control the search engine 1220 based on the information.

According to an embodiment, when an analysis of data is completed to generate an analysis completion result, the compression controller 1200 may update the information related to the compression of data based on the analysis completion result and may control a connection relationship with the search engine 1220 based on the updated information.

According to an embodiment, once the compression controller 1200 obtains the second information, the compression controller 1200 may control the search engine 1220 to be the first structure or the second structure regardless of the analysis result of the portion of data. In addition, when the analysis of data has completed, the compression controller 1200 may update the information related to compression based on the analysis completion result and may control a connection relationship with the search engine 1220 based on the updated information.

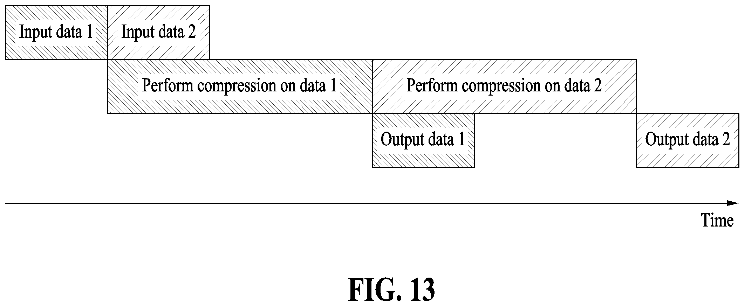

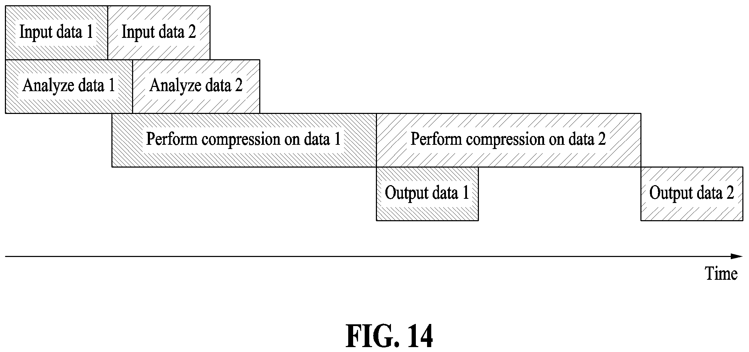

FIGS. 13 and 14 are diagrams illustrating data compression according to an analysis time of data and an input time of the data according to an embodiment of the present disclosure.

Referring to FIG. 13, similar to a case in which a structure of data subject to compression is known in advance, when an analysis of data is not required, a diagram illustrating the compression of data 1 and data 2 is illustrated.

In this case, when data 1 is input, the compression of data 1 may be performed. When an input of data 1 has completed, an input of data 2 may be immediately be performed. When the compression of data 1 has completed, the compression of data 2 may be immediately performed.

On the other hand, referring to FIG. 14, a case in which an analysis of data is required because a structure of the data subject to compression is unknown but an analysis time of the data is longer than an input time of the data is illustrated.

According to an embodiment, as described with reference to FIG. 12, the compression controller may determine information related to the compression of data based on an analysis result of a portion of data 1 and may control the search engine based on the information. When an input of data 1 has completed, the compression controller may perform compression on data 1 based on an analysis result of a portion of data 1. In this case, the search engine performing compression on data 1 may be a search engine controlled based on the analysis result of the portion of data 1. In addition, when the analysis of data has completed, the compression controller may update the information related to the compression of data based on the analysis completion result and may control a connection relationship with the search engine based on the updated information. As a result, the structure of the search engine controlled based on the analysis result of the portion of data 1 may be different from the structure of the search engine controlled based on the analysis completion result of data 1.

According to an embodiment, as described with reference to FIG. 12, when the compression controller obtains the second information, the compression controller may control the search engine to have the first structure or the second structure regardless of the analysis result of the portion of data. In addition, when the analysis of data has completed, the compression controller may update the information related to compression based on the analysis completion result and may control a connection relationship with the search engine based on the updated information. As a result, the structure of the search engine controlled regardless of the analysis result of the portion of data 1 may be different from the structure of the search engine controlled based on the analysis completion result of data 1.

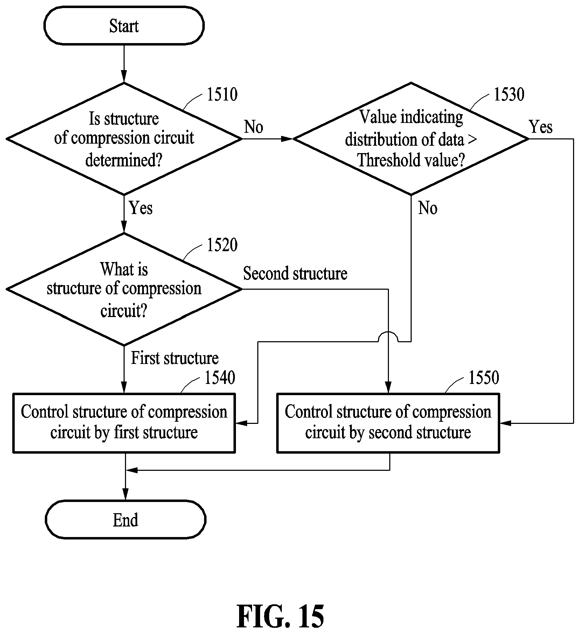

FIG. 15 is a flowchart illustrating an operation of an electronic device according to an embodiment.

Operations to be described hereinafter may be sequentially performed but not necessarily. For example, the order of the operations may change, and at least two of the operations may be performed in parallel. Operations 1510 to 1550 may be performed by at least one component of an electronic device.

In operation 1510, the electronic device determines whether a structure of a search engine is determined.

When a compression controller obtains first information including information related to the compression of data from an SFR, the electronic device may determine that the structure of the search engine is determined.

When the compression controller obtains control information from the SFR causing the compression controller to determine the information related to compression, the electronic device may determine that the structure of the search engine is not determined. In other words, the electronic device may determine the information related to compression based on the control information.

When the structure of the search engine is determined, the electronic device performs operation 1520 based on the determined structure of the search engine. The electronic device may perform operation 1530 when the structure of the search engine is not determined.

In operation 1520, the electronic device determines a type of the structure of the search engine. In other words, the electronic device may determine whether the information related to the compression of data included in the first information is 0 or 1. In operation 1520, when the information related to the compression of data is 0, the electronic device may determine the structure of the search engine to be the first structure. In operation 1520, when the information related to the compression of data is 1, the electronic device may determine the structure of the search engine to be the second structure.

In operation 1530, the electronic device determines whether a value indicating a distribution of data exceeds a threshold value.

When the electronic device does not know the structure of the data subject to compression in advance, the electronic device may perform an analysis of the data. For example, the electronic device may determine the value indicating the distribution of data through an equation for calculating entropy or gini impurity. The electronic device may determine whether the value (in other words, an entropy value or a gini impurity value) indicating the distribution of data exceeds the threshold value.

When the value indicating the distribution of data exceeds the threshold value, the electronic device may determine that the data has the characteristics that the data is not compressed well. Accordingly, the electronic device may determine the information related to the compression of data to be 1 to control a control circuit by a second structure. When the value indicating the distribution of data is less than or equal to the threshold value, the electronic device may determine that the data has the characteristics that the data is compressed well. Accordingly, the electronic device may determine the information related to the compression of data to be 0 to control a control circuit by a first structure.

In operation 1540, the electronic device controls the structure of the search engine by the first structure.

When the value indicating the distribution of data is 0, the electronic device may control the structure of the search engine by the first structure. When the data has the characteristics that the data is compressed well, the electronic device may control the structure of the search engine by the first structure.

In operation 1550, the electronic device controls the structure of the search engine by the second structure. When the value indicating the distribution of data is 1, the electronic device may control the structure of the search engine by the second structure. When the data has the characteristics that the data is not compressed well, the electronic device may control the structure of the search engine by the second structure.

Referring back to FIGs. 1 and 5, according to an embodiment, an electronic device 100 includes a compression unit 160, a search engine 500, and a controller 150. The search engine 500 could be located in the compression unit 160 but embodiments are not limited thereto since the compression unit 160 may merely have access to the search engine 500. In this embodiment, the search engine 500 includes a first buffer 510 having two first sub-buffers 511 and 513, a second buffer 520 having four second sub-buffers 521, 523, 525 and 527, and a plurality of comparators C configured to perform matching between data stored in the first buffer 510 and data stored in the second buffer 120. The controller 150 is configured to determine a region (e.g., 550) comprising all of the second sub-buffers of a first size and one of the first sub-buffers during a first mode, determine the region (e.g., 560) comprising two of the second sub-buffers of a second size larger than the first size and all of the first sub-buffers during a second mode and cause the compression unit 160 to perform compression on target data using the region. The first mode may occur when the target data is not evenly distributed and the second mode may occur when the target data is evenly distributed. Additional selector circuits controlled by selection signals such as those shown in FIG. 6 and FIG. 7 may be present to connect the buffers and/or the sub-buffers to achieve the different configurations of the region. In an embodiment, the size of the region is A x 2B in the first mode and 2A x B in the second mode.

The descriptions provided with reference to FIGS. 1 to 14 may be applicable to each operation shown in FIG. 15, and thus, detailed descriptions thereof have been omitted.

The embodiments described herein may be implemented using a hardware component, a software component and/or a combination thereof. A processing device may be implemented using one or more general-purpose or special-purpose computers, such as, for example, a processor, a controller and an arithmetic logic unit (ALU), a DSP, a microcomputer, an FPGA, a programmable logic unit (PLU), a microprocessor or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, a processing device may include multiple processing elements and multiple types of processing elements. For example, the processing device may include a plurality of processors, or a single processor and a single controller. In addition, different processing configurations are possible, such as parallel processors.

The software may include a computer program, a piece of code, an instruction, or some combination thereof, to independently or uniformly instruct or configure the processing device to operate as desired. Software and data may be stored in any type of machine, component, physical or virtual equipment, or computer storage medium or device capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The methods according to the above-described examples may be recorded in non-transitory computer-readable media including program instructions to implement various operations of the above-described examples. The media may also include, alone or in combination with the program instructions, data files, data structures, and the like. Some of the program instructions recorded on the media may be those specially designed and constructed for the purposes of examples, or they may be of the kind well-known and available to those having skill in the computer software arts. Examples of non-transitory computer-readable media include magnetic media such as hard disks, floppy disks, and magnetic tape; optical media such as CD-ROM discs, DVDs, and/or Blue-ray discs; magneto-optical media such as optical discs; and hardware devices that are specially configured to store and perform program instructions, such as read-only memory (ROM), random access memory (RAM), flash memory (e.g., USB flash drives, memory cards, memory sticks, etc.), and the like. Examples of program instructions include both machine code, such as produced by a compiler, and files containing higher-level code that may be executed by the computer using an interpreter.

The above-described devices may be configured to act as one or more software modules to perform the operations of the above-described examples, or vice versa.

As described above, although the embodiments have been described with reference to certain drawings, a person skilled in the art may apply various technical modifications and variations based thereon. For example, suitable results may be achieved if the described techniques are performed in a different order and/or if components in a described system, architecture, device, or circuit are combined in a different manner and/or replaced or supplemented by other components or their equivalents. Accordingly, implementations other than those described above are within the scope of the following claims.

**Claims**

1.    An electronic device comprising:

a compression unit;
a search engine comprising a first buffer, a second buffer, and a plurality of comparators configured to perform matching between data stored in the first buffer and data stored in the second buffer; and
a compression controller configured to determine a structure of the search engine, adjust a connection between the first buffer and the second buffer based on the determined structure and cause the compression unit to perform compression on target data using the search engine.

2.    The electronic device of claim 1, wherein the search engine comprises:

a first circuit configured to determine a size of the first buffer for transmitting the target data; and
a second circuit configured to determine a size of the second buffer for transmitting the target data.

3.    The electronic device of claim 2, wherein the compression controller is further configured to determine the structure by controlling the first circuit and the second circuit based on information related to compression determined based on the target data.

4.    The electronic device of claim 2 or 3, wherein the search engine comprises:

a third circuit connected to a fourth circuit through a portion of a plurality of comparators and configured to change the connection between the first buffer and the second buffer; and
the fourth circuit connected to the third circuit through a portion of the plurality of comparators and configured to change the connection between the second buffer and the first buffer.

5.    The electronic device of claim 4, wherein the compression controller is further configured to determine the structure by controlling the third circuit and the fourth circuit based on information related to compression determined based on the target data.

6.    The electronic device of one of claims 1 to 5, wherein the compression controller is further configured to determine the structure of the search engine to be a first structure or a second structure,

in the first structure, a size of the second buffer is greater than in the second structure, and
in the second structure, a size of the first buffer is greater than in the first structure.

7. The electronic device of claim 6, wherein, in the first structure, the size of the second buffer is at least twice as large as it is in the second structure, and
in the second structure, the size of the first buffer is at least twice as large as it is in the first structure.

8. The electronic device of one of claims 1 to 7, wherein the compression controller is further configured to change the structure of the search engine based on information related to compression determined based on the target data.

9. The electronic device of claim 8, wherein the compression controller is further configured to determine the structure according to the information related to compression predetermined based on a structure of the target data.

10. The electronic device of claim 8 or 9, wherein the compression controller is further configured to obtain a value indicating a distribution of the data obtained by an analysis of the target data, determine the information related to compression based on whether the value exceeds a threshold value, and determine the structure based on the information related to compression.

11. The electronic device of claim 10, wherein the compression controller is further configured to:

when an analysis time of the target data is longer than a movement time of the target data, adjust the connection by determining the information related to compression based on an analysis result of a portion of the target data, and
when the analysis of the target data has completed, update the information related to compression based on a completed analysis result, and adjust the connection based on the updated information related to compression.

12. The electronic device of one of claims 1 to 11, wherein the compression controller is further configured to cause the compression unit to store information indicating the structure of the search engine together with compressed target data.

13. An operation method of an electronic device having a host processor and a compression controller, the method comprising:

providing, by the host processor, a compression command for target data subject to compression; and
determining, by the compression controller, a structure of a search engine;
adjusting, by the compression controller, a connection between a first buffer and a second buffer included in the search engine based on information related to compression determined based on the target data upon receipt of the compression command from the host processor; and
causing, by the compression controller, a compression unit to perform compression on the target data subject to compression using the search engine.

**FIG. 1**

FIG. 2

EP 4 651 382 A1

**FIG. 3**

**FIG. 4**

**FIG. 5**

EP 4 651 382 A1

**FIG. 6**

700

First buffer

770

780

Second
buffer
#3
760

Second
buffer
#2
750

Selector
2x1 720

0                          1

Second
buffer
#1
740

Second
buffer
#0
730

0          Selector          1
          1x2 710

Information
related to compression of data

Data

**FIG. 7**

First buffer [255]  First buffer [127]  First buffer [254]  First buffer [126]  · · ·  ⌐ 800  First buffer [128]  First buffer [0]

Information related to compression of data

| 0 | Selector 8001 | 1 |
| 0 | Selector 8002 | 1 |
· · ·
| 0 | Selector 8128 | 1 |

C    C    · · ·    C

## FIG. 8

**FIG. 9**

FIG. 10

| Data<br>1100 |
| :---: |

↓ Compression

| Metadata<br>1120 | Compressed data<br>1110 |
| :---: | :---: |

# FIG. 11

**Compression unit 1210**

| Selector | RAM 0 | Selector | Search engine 1220 | Compression engine 1250 | Selector | RAM 0 | Selector |
| | RAM 1 | | | | | RAM 1 | |

Data →

→ Compressed data

Analyzer
1230

Value indicating
distribution of data

Information
related to compression
of data

First
information

Threshold
value

Second
information

SFR
1240

Compression
controller
1200

**FIG. 12**

| Input data 1 | Input data 2 | | |
|---|---|---|---|
| | Perform compression on data 1 | Perform compression on data 2 | |
| | | Output data 1 | Output data 2 |

Time

**FIG. 13**

FIG. 14

Start

1510
Is structure
of compression circuit
determined?

No →

1530
Value indicating
distribution of data >
Threshold value?

Yes

No

Yes

1520
What is
structure of compression
circuit?

Second structure

First structure

1540
Control structure of compression
circuit by first structure

1550
Control structure of compression
circuit by second structure

End

**FIG. 15**

Europäisches
Patentamt

European
Patent Office

Office européen
des brevets

# EUROPEAN SEARCH REPORT

**Application Number**

EP 25 16 9402

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/004738 A1 (WU FANGFANG [CN] ET AL) 3 January 2019 (2019-01-03) | 1-10,12, 13 | INV.<br>H03M7/28 |
| A | * paragraph [0021] - paragraph [0025]; figures 3, 4 * | 11 | H03M7/30 |
| X | US 2020/162101 A1 (BECKMAN EDWARD DAVID [US] ET AL) 21 May 2020 (2020-05-21) | 1-10,12, 13 | |
| A | * paragraph [0099]; figures 7a, 7b, 13 *<br>* paragraph [0107] - paragraph [0109] *<br>* paragraph [0131] *<br>* paragraph [0162] - paragraph [0163] * | 11 | |

**TECHNICAL FIELDS
SEARCHED      (IPC)**

H03M
G06F

The present search report has been drawn up for all claims

| Place of search | Date of completion of the search | Examiner |
|---|---|---|
| The Hague | 26 August 2025 | Belardinelli, Carlo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 9402

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2025

| Patent document cited in search report | Publication date | Patent family member(s) | Publication date |
|---|---|---|---|
| US 2019004738 A1 | 03-01-2019 | CN 107317584 A | 03-11-2017 |
| | | US 2019004738 A1 | 03-01-2019 |
| US 2020162101 A1 | 21-05-2020 | NONE | |

EPO FORM P0459

For more details about this annex : see Official Journal of the European Patent Office, No. 12/82